# EUROPEAN PATENT APPLICATION

(11) **EP 2 423 351 A1**
(43) Date of publication of application: **29.02.2012**
(21) Application number: 10766805.5
(22) Date of filing: 14.04.2010
(51) Int. Cl.: C23C 14/56, C23C 14/50, C23C 16/54

(54) **APPARATUS FOR FORMING THIN FILM AND METHOD FOR FORMING THIN FILM**

(30) Priority: 22.04.2009 JP 2009104192
(71) Applicant: Panasonic Corporation, Kadoma-shi Osaka 571-8501 (JP)
(72) Inventor: Shinokawa Yasuharu, Osaka 540-6207 (JP); Shibutani,Satoshi, Osaka 540-6207 (JP); Honda ,Kazuyoshi, Osaka 540-6207 (JP); Kamiyama,Yuma, Osaka 540-6207 (JP); Yamamoto ,Masahiro, Osaka 540-6207 (JP)
(74) Representative: TBK
(86) International application number: PCT/JP2010/002709
(87) International publication number: WO 2010/122742

(57) **Abstract**

In a film forming method using gas cooling, a decrease in a film formation rate and an excessive load on a vacuum pump due to gas introduction are avoided while achieving an adequate cooling effect. A thin film forming device of the present invention includes: a cooling body 10 having a cooling surface 10S located near a rear surface of a substrate 7 in a thin film forming region 9; and a gas introducing unit configured to introduce a gas to between the cooling surface 10S and the rear surface of the substrate 7. In a width-direction cross section of the substrate, a center portion of the cooling surface is shaped to project toward the rear surface of the substrate 7 as compared to both end portions of the cooling surface. In the width-direction cross section of the substrate, the cooling surface preferably has a bilaterally-symmetric shape and more preferably has a shape represented by a catenary curve.

## Description

### Technical Field

The present invention relates to a thin film forming device and a thin film forming method.

### Background Art

A thin film formation technology is widely used to enhance device performances and reduce device sizes. Utilizing thin films in devices brings direct merits to users, and in addition, plays an important role from an environmental point of view, such as protection of earth resources and a reduction in power consumption.

For the development of the thin film formation technology, it is essential to respond to demands from industrial use aspects, such as increases in efficiency, stability, and productivity of a thin film manufacturing method and a reduction in cost of the thin film manufacturing method. Efforts toward these are being continued.

To improve the productivity of the thin film, the thin film formation technology capable of achieving high deposition rate is essential. Therefore, an increase in deposition rate is being promoted in the thin film manufacturing method, such as vacuum deposition, sputtering, ion plating, or CVD.

Used as a method for continuously forming a large amount of thin film is a take-up type thin film manufacturing method. The take-up type thin film manufacturing method is a method for: pulling out an elongated substrate from a pull-out roll, the elongated substrate being rolled in a roll shape; forming a thin film on the substrate while the substrate is being fed along a feed system; and then taking up the substrate by a take-up roll. By combining with a high deposition rate film forming source, such as a vacuum deposition source using an electron beam, the take-up type thin film manufacturing method can form the thin film with high productivity.

As a factor determining whether such continuous take-up type thin film manufacturing succeeds or fails, there is a problem of a heat load during film formation. For example, in the vacuum deposition, heat radiation from an evaporation source and heat energy of evaporated atoms are applied to the substrate, and this increases the temperature of the substrate. The temperature of the substrate excessively increases especially in a case where the temperature of the evaporation source is increased to increase the deposition rate or the evaporation source and the substrate are provided near each other. However, if the temperature of the substrate excessively increases, a mechanical property of the substrate deteriorates significantly, and problems, such as significant deformation of the substrate and meltdown of the substrate, tend to occur by thermal expansion of the deposited thin film and the substrate. In the other film formation method, although a heat source is different from the above, the heat load is applied to the substrate during the film formation, and the same problems occur.

To prevent the deformation, meltdown, and the like of the substrate, the substrate is cooled during the film formation. The film formation with the substrate placed along a cylindrical can disposed on a passage of the feed system is widely performed for the purpose of cooling the substrate. Since thermal contact between the substrate and the cylindrical can is secured by this method, heat can be released to the cooling can having high heat capacity. Therefore, the temperature increase of the substrate can be prevented, and the temperature of the substrate can be maintained at a specific cooling temperature.

One of methods for securing the thermal contact between the substrate and the cylindrical can in a vacuum atmosphere is a gas cooling method. The gas cooling method is a method for cooling the substrate such that: a small gap of several millimeters or less is kept between the substrate and the cylindrical can that is a cooling body; a minute amount of gas is supplied to the gap; and the thermal contact between the substrate and the cylindrical can is secured by utilizing gas heat conduction. PTL 1 describes that in a device for forming the thin film on a web that is the substrate, a gas is introduced to between the web and the cylindrical can that is a supporting unit. In accordance with this, since the thermal conduction between the web and the supporting unit can be secured, the temperature increase of the web can be suppressed.

As a unit for cooling the substrate, a cooling belt can also be used instead of the cylindrical can. In the case of forming the film by oblique incidence, forming the film with the substrate traveling linearly is advantageous from a viewpoint of the use efficiency of a material. In this case, it is effective to use the cooling belt as the substrate cooling unit. PTL 2 discloses a method for cooling a belt in a case where the belt is used to feed and cool the material of the substrate. In accordance with PTL 2, in order to further cool a cooling band, a cooling mechanism using a double or more cooling band or a liquid medium is provided inside the cooling body. With this, the cooling efficiency can be increased. Therefore, magnetic tape characteristics, such as an electromagnetic conversion characteristic, can be improved, and the productivity can also be improved significantly.

### Citation List

### Patent Literature

PTL 1: Japanese Laid-Open Patent Application Publication No. 1-152262
PTL 2: Japanese Laid-Open Patent Application Publication No. 6-145982

### Summary of Invention

### Technical Problem

In the case of forming the film by the oblique incidence, forming the film using the cooling belt described in PTL 2 with the substrate traveling linearly is advantageous from a viewpoint of the use efficiency of the material. However, in the film formation using the cooling belt, especially in a case where the heat load on the substrate is high due to, for example, a high film formation rate, it is difficult to adequately cool the substrate. This is because in a case where the substrate travels linearly, a normal-direction power of the substrate cannot be obtained, and a power toward the cooling body cannot be secured. In a case where the power of the substrate toward the cooling body is not secured, the thermal contact between the substrate and the cooling body cannot be secured adequately.

In the case of performing the gas cooling described in PTL 1 in order to adequately secure the thermal contact between the substrate and the cooling body, increasing the pressure of the cooling gas between the substrate and the cooling body is effective to improve a cooling performance. Therefore, it is desirable to increase the gas pressure between the substrate and the cooling body by setting the gap between the substrate and the cooling body as small as possible and adjusting an introduction amount of the cooling gas to be large.

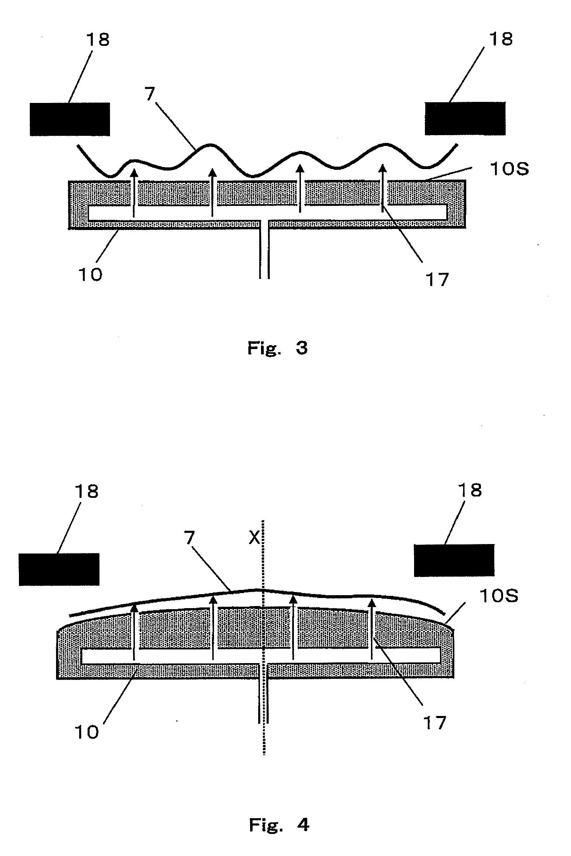

However, when the temperature of the substrate increases, the thermal expansion of the substrate occurs. Since tension is applied to the substrate in a longitudinal (feed) direction of the substrate by the feed system, the influence on the substrate by the thermal expansion is small. However, since the tension is not applied to the substrate in a width direction of the substrate, the influence on the substrate by the thermal expansion is significant. To be specific, as shown in Fig. 3, wrinkles and undulations tend to be generated on the substrate by the thermal expansion. As a result, since the distance between the substrate and the cooling body increases partially or entirely, the gas pressure decreases, and this deteriorates the cooling performance. Further, the cooling gas easily leaks through the increased gap, and this increases the pressure in a film forming chamber. Thus, the film formation rate deteriorates, and in addition, an excessive load is applied to a vacuum pump configured to reduce the pressure in the film forming chamber.

In consideration of the above problems, an object of the present invention is to provide a thin film forming device and a thin film forming method, each of which can uniformly and adequately cool the substrate using the cooling gas by preventing the generation of the wrinkles and undulations and maintaining a constant distance between the substrate and the cooling body when continuously forming the thin film on the surface of the substrate while feeding the substrate in vacuum, the wrinkles and undulations being generated due to the thermal expansion in the width direction of the substrate.

### Solution to Problem

In order to solve the above problems, a thin film forming device of the present invention is a thin film forming device configured to form a thin film in vacuum on a front surface of a band-shaped substrate having the front surface and a rear surface, the thin film forming device including: a feed mechanism configured to feed the substrate; a thin film forming unit configured to form the thin film on the front surface of the substrate in a thin film forming region while the substrate is being fed; a cooling body configured to have a cooling surface located near the rear surface in the thin film forming region and to be cooled by a cooling medium; a gas introducing unit configured to introduce a cooling gas to between the cooling surface and the rear surface to cool the substrate; and a vacuum container configured to contain the feed mechanism, the thin film forming unit, the cooling body, and the gas introducing unit, wherein in a width-direction cross section of the substrate, a center portion of the cooling surface is shaped to project toward the rear surface as compared to both end portions of the cooling surface.

A thin film forming method of the present invention is a thin film forming method for forming a thin film in vacuum on a front surface of a band-shaped substrate having the front surface and a rear surface, the method including: a placing step of placing a cooling surface near the rear surface in a thin film forming region; and a thin film forming step of, while the substrate is being fed, introducing a cooling gas to between the cooling surface and the rear surface to cool the substrate and forming the thin film on the front surface of the substrate in the thin film forming region, wherein in a width-direction cross section of the substrate, a center portion of the cooling surface is shaped to project toward the rear surface as compared to both end portions of the cooling surface.

### Advantageous Effects of Invention

In accordance with the present invention, when performing the gas cooling for the purpose of preventing the deformation and meltdown of the substrate due to a heat load during the film formation in the case of continuously forming the thin film on the front surface of the substrate while feeding the substrate in vacuum, the center portion of the cooling surface of the cooling body provided near the rear surface of the substrate is shaped to project toward the rear surface in the width-direction cross section of the substrate. Therefore, even if the thermal expansion of the substrate in the width direction occurs due to the temperature increase of the substrate, the distance between the substrate and the cooling body can be maintained substantially constant, that is, can be an extremely short distance, such as several millimeters or shorter. With this, the substrate center portion which significantly deforms by the thermal expansion can be more efficiently cooled. Therefore, the amount of gas leaking from the gap between the cooling body and the substrate can be reduced while achieving the adequate cooling effect in the entire thin film forming region. On this account, the decrease in the film formation rate due to the pressure increase in the film forming chamber can be avoided, and the unnecessary load on the vacuum pump can be reduced.

### Brief Description of Drawings

[Fig. 1] Fig. 1 is a schematic side view showing the configuration of an entire film forming device of Embodiment 1 of the present invention.
[Fig. 2A] Fig. 2A is an enlarged substrate longitudinal-direction cross-sectional view showing the vicinity of a thin film forming region of Fig. 1.
[Fig. 2B] Fig. 2B is a cross-sectional view taken along line A-A' of Fig. 2A.
[Fig. 3] Fig. 3 is a substrate width-direction cross-sectional view schematically showing the relation between the substrate and a conventional cooling surface having a linear shape in a width-direction cross section.
[Fig. 4] Fig. 4 is a substrate width-direction cross-sectional view schematically showing the relation between the substrate and a cooling surface of the present invention, the cooling surface having a projecting shape in the width-direction cross section.
[Figs. 5A and 5B] Figs. 5A and 5B are substrate longitudinal-direction cross-sectional views each showing the positional relation between a cooling body and an auxiliary roller in Embodiment 1 of the present invention. Fig. 5A is a cross-sectional view when the film formation is not performed. Fig. 5B is a cross-sectional view during the film formation.
[Fig. 6] Fig. 6 is a schematic side view showing the configuration of the entire film forming device of Embodiment 2 of the present invention.
[Fig. 7] Fig. 7 is a structure diagram showing a cooling body 10 of Fig. 6 and its vicinity when viewed from the front surface side of a substrate 7.
[Fig. 8] Fig. 8 is a structure diagram corresponding to Fig. 7 except that the substrate 7 and a blocking plate 31b are omitted.
[Fig. 9A] Fig. 9A is a cross-sectional view taken along line A-A' of Fig. 7.
[Fig. 9B] Fig. 9B is an enlarged view showing blocking plates 31a and 31b of Fig. 9A and their vicinities.
[Fig. 10] Fig. 10 is a cross-sectional view taken along line B-B' of Fig. 8.
[Fig. 11] Fig. 11 is a schematic side view showing the configuration of the entire film forming device of Embodiment 3 of the present invention.
[Fig. 12] Fig. 12 is an enlarged side surface cross-sectional view showing the cooling body 10 of Fig. 11 and its vicinity.
[Fig. 13] Fig. 13 is an enlarged substrate longitudinal-direction cross-sectional view showing the vicinity of the thin film forming region in the film forming device of Embodiment 4 of the present invention.
[Fig. 14] Fig. 14 is a cross-sectional view taken along line A-A' of Fig. 13 in the case of using a conventional rotary cooling body in which the cooling surface has a linear shape in the width-direction cross section.
[Fig. 15] Fig. 15 is a cross-sectional view taken along line A-A' of Fig. 13 in the case of using a rotary cooling body of the present invention, the rotary cooling body being configured such that the cooling surface has a projecting shape in the width-direction cross section.

### Description of Embodiments

### Embodiment 1

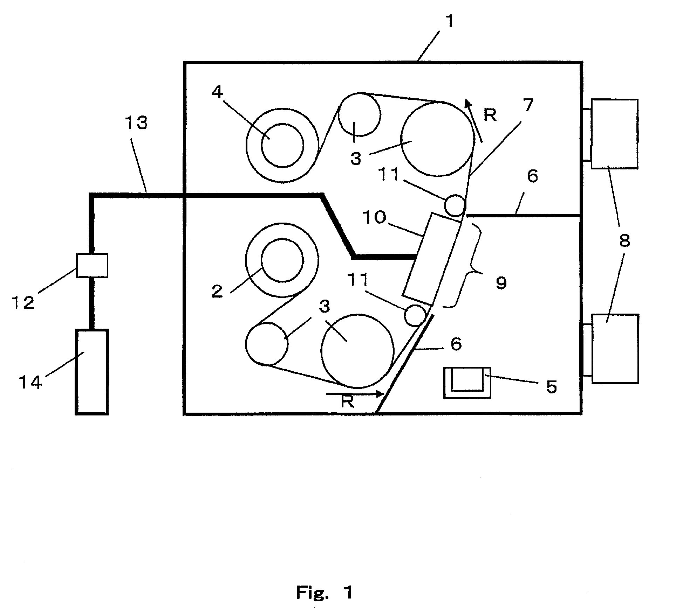

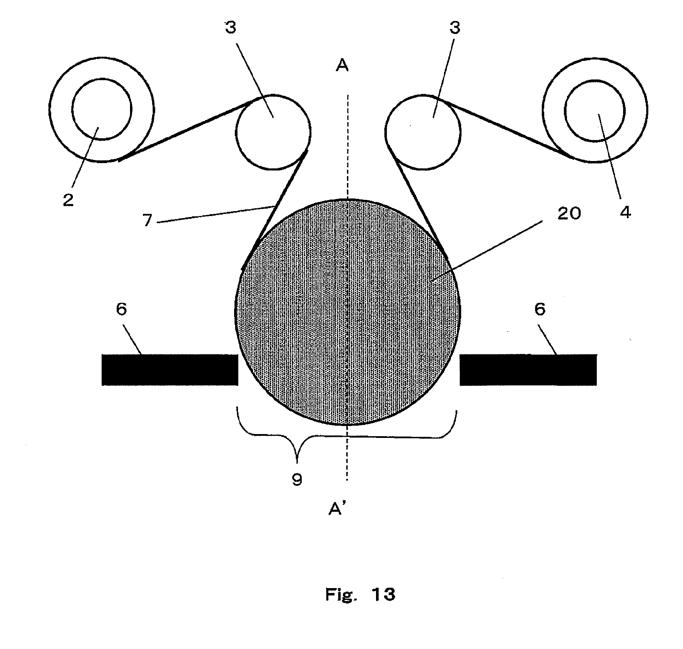

Fig. 1 is a side view schematically showing the configuration of an entire film forming device of Embodiment 1 of the present invention in a case where a substrate is linearly fed in a thin film forming region. Here, the expression "a substrate is linearly fed" intends to omit a case where as shown in Fig. 13, the substrate is fed in a curved state along a cylindrical can. Specifically, the above expression denotes that as shown in Fig. 1, the substrate is fed in a state where tension is applied to the substrate in a feed direction R by a plurality of rollers. However, in the side view of Fig. 1, the above expression includes not only a case where the substrate is fed on a completely linear line but also a case where the substrate is fed on a linear feed passage including a slightly curved portion(s).

A vacuum container 1 is a pressure-resistant container-like member having an internal space. A pull-out roller 2, a plurality of feed rollers 3, a thin film forming region 9, a take-up roller 4, a film forming source 5, and a shielding plate 6 are contained in the internal space. The pull-out roller 2 is a roller-like member provided to be rotatable around a center axis thereof. A band-shaped elongated substrate 7 winds around a surface of the pull-out roller 2. The pull-out roller 2 supplies the substrate 7 to the nearest feed roller 3.

Each of the feed rollers 3 is a roller-like member provided to be rotatable around a center axis thereof. The feed rollers 3 guide the substrate 7, supplied from the pull-out roller 2, to the thin film forming region 9 and finally guide the substrate 7 to the take-up roller 4. When the substrate 7 travels the thin film forming region 9, material particles flying from the film forming source 5 reacts with a material gas introduced from the material gas introduction tube (not shown) according to need to be deposited on a front surface of the substrate 7. Thus, a thin film is formed on the front surface of the substrate 7. The take-up roller 4 is a roller-like member provided to be rotatable by a driving unit, not shown. The take-up roller 4 takes up and holds the substrate 7 having the front surface on which the thin film is formed.

Various film forming sources can be used as the film forming source 5. Examples are evaporation sources using resistance heating, induction heating, and electron beam heating, ion plating sources, sputtering sources, and CVD sources. In addition, as the film forming source 5, a combination of an ion source and a plasma source can be used. For example, the film forming source 5 includes a container-like member and a film forming material. The container-like member is provided under a lowermost portion of the thin film forming region 9 in a vertical direction, and a vertically upper portion thereof is open. The film forming material is mounted inside the container-like member. A heating unit (not shown), such as an electron gun or an induction coil, is provided in the vicinity of the film forming source 5. The film forming material in the container-like member is heated and evaporates by the heating unit. The steam of the material moves upward in the vertical direction to adhere to the front surface of the substrate 7 in the thin film forming region 9. Thus, the thin film is formed. The film forming source 5 applies a heat load to the substrate during the film formation.

The shielding plate 6 limits a region where the material particles flying from the film forming source 5 contact the substrate 7 to only the thin film forming region 9.

An exhaust unit 8 is provided outside the vacuum container 1 and adjusts the inside of the vacuum container 1 to a pressure reduced state suitable for the formation of the thin film. For example, the exhaust unit 8 is constituted by each of various vacuum exhaust systems including as a main pump an oil diffusion pump, a cryopump, a turbo-molecular pump or the like.

A cooling body 10 is provided near the substrate on a rear surface (surface opposite to the front surface on which the film is formed) side of the substrate 7 located in the thin film forming region 9.

A pair of auxiliary rollers (adjusting units) 11 are respectively provided on a front side and rear side of the cooling body 10 along the feed passage of the substrate 7 and contact the rear surface of the substrate 7. This facilitates the adjustment of the feed passage of the substrate 7 in the vicinity of the thin film forming region 9 and the fine adjustment of the distance between the substrate and the cooling body.

A cooling gas is introduced from a cooling gas supply unit 14 through a gas pipe 13 to between the cooling body 10 and the rear surface of the substrate. The introduction amount of the gas is controlled by a gas flow controller 12. The introduced gas transfers the coldness of the cooling body 10 to cool the substrate 7. Examples of the cooling gas supply unit 14 are a gas bomb and a gas generator.

The type of the cooling gas is not especially limited, and helium, argon, oxygen, or the like may be used. However, it is preferable to use a gas having a heat transfer performance which is the highest when the performance is measured under the same pressure condition. From this viewpoint, helium is especially preferable. The heat transfer performance under low pressure is expressed by a heat transfer coefficient (unit: W/cm²/K). The heat transfer coefficient can be calculated by dividing the amount of heat transfer between two flat surfaces per unit area in a steady state by a temperature difference. As a result of an experiment for obtaining the heat transfer coefficients of helium, argon, and oxygen gases, the heat transfer coefficients (unit: W/cm²/K) shown in Table 1 were obtained. It is clear from this result that the gas suitable for effectively performing the heat transfer is helium. In this experiment, the pressure was set to 100 Pa (measured by a Pirani gauge), and a flat copper plate of 10 centimeters square was used as a flat plate.

**Table 1**

| | Gap = 0.5 mm | Gap = 3 mm |
|---|---|---|
| Helium | 0.00714 | 0.00456 |
| Argon | 0.00312 | 0.00126 |
| Oxygen | 0.00410 | 0.00161 |

A material of the cooling body 10 is not especially limited. Examples are metals, such as copper, aluminum, and stainless steel, which can secure a worked shape, carbons, various ceramics, and engineering plastics. Especially, it is more preferable to use the metal, such as copper or aluminum, having high heat conductivity, since such metal is unlikely to generate dust and excels in heat resistance, and the temperature of such metal is easily uniformized.

The cooling body 10 is cooled by a cooling medium. The cooling medium is normally a liquid or gas material and is typically water. A cooling medium channel (not shown) is provided to contact the cooling body 10 or is embedded in the cooling body 10. The cooling medium flows through the cooling medium channel to cool the cooling body 10. In the case of using a pipe as the cooling medium channel, the material of the pipe is not especially limited. For example, a copper or stainless-steel pipe can be used. The pipe may be attached to the cooling body 10 by, for example, welding. Moreover, a hole through which the cooling medium flows may be directly formed in the cooling body 10 to form the cooling medium channel.
A cooling performance for cooling the substrate 7 is adjustable by changing various conditions. Examples of such conditions are the type, flow rate, and temperature of the cooling medium for cooling the cooling body 10, the flow rate, type, and temperature of the gas introduced to between the cooling body 10 and the rear surface of the substrate (gas introduction conditions), and the distance between the cooling body 10 and the substrate 7, the distance being adjusted by, for example, the auxiliary rollers 11. Only one of these conditions may be adjusted, or two or more conditions may be adjusted in combination.

As above, in accordance with the thin film forming device of Fig. 1, the substrate 7 supplied from the pull-out roller 2 travels through the feed rollers 3 and is supplied with the steam flying from the evaporation source 5, and according to need, oxygen, nitrogen, or the like in the thin film forming region 9. Thus, the thin film is formed on the substrate. The substrate 7 travels through the other feed rollers 3 to be taken up by the take-up roller 4. With this, the substrate 7 having the front surface on which the thin film is formed is obtained.

Various polymer films, various metal foils, a complex of the polymer film and the metal foil, and elongated substrates of the other materials can be used as the substrate 7. Examples of the polymer film are polyethylene terephthalate, polyethylene naphthalate, polyamide, and polyimide. Examples of the metal foil are aluminum foils, copper foils, nickel foils, titanium foils, and stainless steel foils. The substrate has a width of, for example, 50 to 1,000 mm and desirably has a thickness of, for example, 3 to 150 µm. In a case where the substrate has a width of less than 50 mm, a large amount of gas leaks during the gas cooling. However, the present invention is not inapplicable to this case. In a case where the substrate has a thickness of less than 3 µm, the heat capacity of the substrate is extremely small, so that the heat deformation easily occurs. In a case where the substrate has a thickness of more than 150 µm, the substrate is substantially inextensible even by the tension applied by the pull-out roller 2 or the take-up roller 4. Therefore, the partial distortion of the substrate cannot be prevented, and the large gap between the cooling body and the substrate is easily formed. Thus, a large amount of gas leaks during the gas cooling. However, the present invention is not inapplicable to these cases. A feed speed of the substrate differs depending on the type of the thin film to be formed and conditions for the film formation, but is, for example, 0.1 to 500 m/min. The tension applied to the substrate being fed in the feed direction R is suitably selected depending on the material and thickness of the substrate and process conditions, such as a film formation rate.

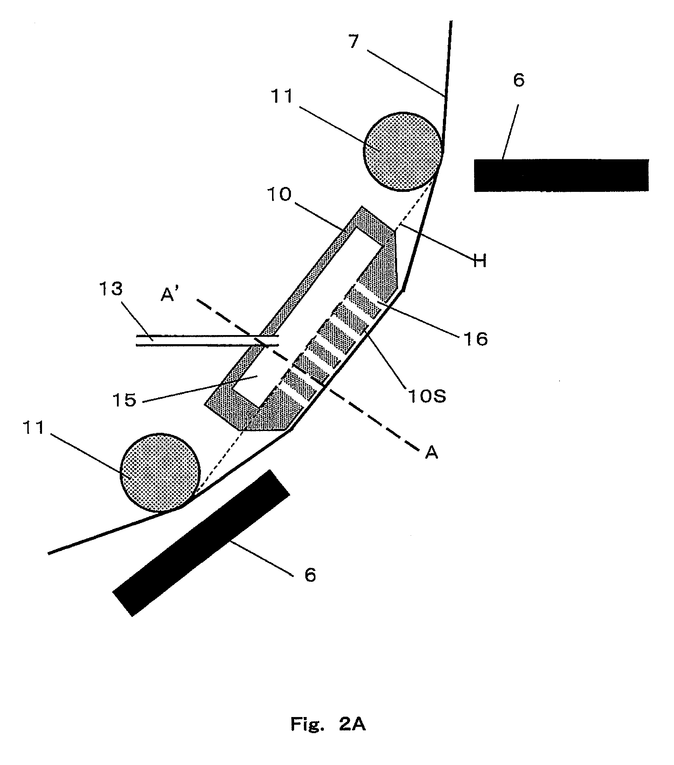

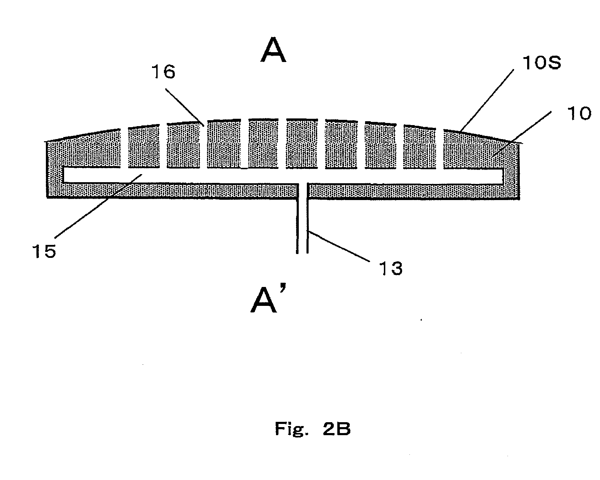

Fig. 2A is an enlarged cross-sectional view showing the vicinity of the thin film forming region 9 of the film forming device of Fig. 1. Fig. 2B is a cross-sectional view taken along line A-A' of Fig. 2A (the substrate 7 is omitted).

As a method for introducing the gas to between the cooling body 10 and the substrate 7, various methods can be used. For example, as shown in Fig. 2A, a manifold 15 connected to the gas pipe 13 is formed inside the cooling body 10. The gas is supplied from the manifold 15 through a plurality of gas introduction holes 16 extending to a cooling surface (surface opposed to the rear surface of the substrate 7) 10S of the cooling body 10. Another method is a method for embedding in the cooling body a gas nozzle having, for example, a flute-like outlet shape and introducing the gas from the nozzle. Still another method is a method for using a porous sintered metal, porous ceramic, or the like as the material of the cooling body 10 and introducing the gas through its fine holes. The gas introducing method is not limited to these. Any other method may be used as long as it can introduce the gas as the heat transfer medium to between the cooling body and the substrate while controlling the gas.

It is preferable that the area of one gas introduction hole 16 (the area of one opening on the cooling surface 10S) in Figs. 2A and 2B be 0.5 to 20 mm². The area of smaller than 0.5 mm² is not preferable since the opening tends to be clogged with film formation particles. The area of larger than 20 mm² is not preferable since the pressures of the gases introduced through respective holes tend to vary, and uneven cooling occurs in a substrate width direction and a substrate longitudinal direction.

The plurality of gas introduction holes 16 may be arranged on the cooling surface 1OS at regular intervals. If the amount of gas leakage from between the cooling body and the substrate is large, the arrangement of the gas introduction holes 16 and the sizes of the gas introduction holes 16 may be adjusted such that the flow rate of the gas becomes high in the vicinities of both width-direction end portions of the substrate. The gas introduction holes 16 are arranged in seven rows in the substrate longitudinal direction of the cooling body 10 (Fig. 2A) and nine rows in the substrate width direction of the cooling body 10 (Fig. 2B). However, the present embodiment is not limited to this.

In the present invention, as shown in Fig. 2B, when the cooling surface 10S of the cooling body 10 is observed in a substrate width-direction cross section of the cooling body 10, a center portion of the cooling surface 10S is shaped to project toward an upper side in Fig. 2B (toward the rear surface of the substrate in Fig. 2A) as compared to both end portions of the cooling surface 10S. With this, even if the thermal expansion of the substrate in the substrate width direction occurs due to the temperature increase of the substrate, as shown in Fig. 4, the distance between the substrate and the cooling body can be made short and maintained substantially constant. Thus, while achieving an adequate cooling effect, the amount of gas leakage from between the cooling body and the substrate can be reduced, and an adverse influence on the film formation rate and an unnecessary load on the vacuum pump can be reduced.

Fig. 3 is a substrate width-direction cross-sectional view schematically showing the relation between the substrate and a conventional cooling surface whose width-direction shape is a flat surface as with PTL 1. Fig. 4 is a substrate width-direction cross-sectional view schematically showing the relation between the substrate and the projecting cooling surface of the present invention. When forming the thin film on the substrate being fed, the temperature of the substrate increases during the film formation, and the thermal expansion of the substrate occurs. Since the tension in the substrate width direction is not applied to the substrate, deflections tend to be generated. Therefore, in the case of using the conventional cooling body having the linear cooling surface in the substrate width-direction cross section, wrinkles and undulations tend to be generated on the substrate (Fig. 3). As a result, since the distance between the substrate and the cooling body increases partially or entirely, the gas pressure between the substrate and the cooling body decreases, and this deteriorates the cooling performance. Further, the cooling gas tends to leak from the enlarged gap. If the flow rate (gas pressure) of the cooling gas is increased in order to obtain an appropriate cooling performance, the amount of gas leakage from between the substrate and the cooling body also increases. If the amount of gas leakage increases, the film formation rate decreases, and an unnecessary load on the vacuum pump is generated.

In the case of using the cooling body of the present invention in which the center portion of the cooling surface projects in the substrate width-direction cross section, wrinkles and undulations are unlikely to be generated even by the thermal expansion of the substrate. Therefore, the distance between the substrate and the cooling body can be made short and maintained substantially constant (Fig. 4). With this, without spoiling the appropriate cooling effect, the total amount of introduced gas can be reduced, the amount of gas leakage from between the substrate and the cooling body can be reduced, and the decrease in the film formation rate and the load on the vacuum pump can be avoided.

It is preferable that in the cooling body of the present invention, the cooling surface have a projecting shape in the substrate width-direction cross section, and in addition, have a bilaterally-symmetric shape. In this shape, as shown in Fig. 4, a portion which projects most toward the rear surface of the substrate is located at a center portion in the substrate width-direction cross section. The above "bilaterally-symmetric" denotes that the substrate width-direction cross section of the cooling surface is line-symmetric with respect to a normal line X of the cooling surface 10S at the most projecting center portion. To prevent the heat load on the cooling body and the contamination by the material particles, the surfaces of both end portions of the substrate in the substrate width direction are normally shielded from the film forming source by a mask 18, so that the thin film is not formed on these surfaces. Therefore, the change in shape of both substrate width-direction end portions by the temperature increase becomes small, and the tension in the longitudinal direction is easily applied to the substrate. Therefore, since the most projecting portion is located at the center portion of the substrate width-direction cross section, the substrate 7 can spread along the cooling surface 10S in an overall balanced manner in the width direction.

Among the line-symmetric projecting shapes, a line-symmetric projecting shape in which the width-direction cross section of the cooling surface has a shape shown by a catenary curve is especially preferable. In this case, the wrinkles and undulations generated on the substrate due to the introduction of the cooling gas are most unlikely to be generated.

The projecting shape of the cooling surface can be optimized in consideration of various film formation conditions, such as the film formation rate (evaporation rate, for example), the temperature of the film forming source, the distance between the film forming source and the substrate, a substrate traveling speed, and the type (material, thickness, width) of the substrate. In a specific example, the projecting shape of the cooling surface can be optimized based on the amount of extension of the substrate due to temperature differences among respective points on the substrate and the catenary curve. In this case, a width L of the substrate when expanded is calculated by L (mm) = {(Ta-Tmin)xa+1}×S, where S (mm) denotes the width of the substrate, Tmin (°C) denotes a minimum temperature in the substrate width direction (for example, a temperature at each of both substrate end portions shielded by the mask 18), Ta (°C) denotes an average temperature in the substrate width direction, and α denotes a linear expansion coefficient of the substrate. Further, a catenary number C is calculated by an equation of the catenary curve, that is, by L = 2Csinh(S/2C). The amount of sag y (mm) at a substrate width-direction position x (mm) is calculated by the catenary curve, that is, by y = C(cosh(x/C)-1), obtained by the catenary number C. The projecting cooling surface most suitable for an arbitrary temperature distribution can be designed by repeatedly performing this operation in the substrate longitudinal direction.

For example, if the temperature distribution on a film formed surface of the substrate in the substrate longitudinal direction is uniform, the cooling surface has the projecting shape in the substrate width-direction cross section but has the linear shape in a substrate longitudinal-direction cross section. In contrast, if the temperature distribution on the film formed surface in the substrate longitudinal direction varies due to a traveling direction of the substrate, a film formation incidence angle, and the like, the cooling surface has a projecting portion, a depressed portion, or an inclined shape in the substrate longitudinal-direction cross section in accordance with the variation in the temperature distribution on the film formed surface. As above, in the present invention, the shape of the cooling surface in the substrate longitudinal-direction cross section is not especially limited and can be suitably optimized in accordance with the temperature distribution on the film formed surface.

The temperature distribution on the film formed surface can be determined by, for example, a method for measuring the temperature on the surface of the substrate by thermography or radiation thermometer during the heating (during the film formation) or a method for placing a thermocouple in contact with the rear surface of the substrate to monitor the temperature.

Thus, the shape of the cooling surface is adjusted in accordance with the distribution of the heat load on the substrate from the film forming source. To be specific, the temperature distribution of the substrate during the film formation is estimated or measured, the amount of expansion of the substrate is estimated, and the shape of the cooling surface is adjusted to be most appropriate in accordance with the amount of expansion. With this, the total amount of introduced gas can be minimized while preventing the increase in the distance between the substrate and the cooling body due to the deformation of the substrate and obtaining the appropriate cooling effect.

It is preferable that the pair of auxiliary rollers and the cooling body be provided such that when forming the thin film on the front surface of the substrate, a part of the cooling surface having the projecting shape or the entire cooling surface projects toward the rear surface of the substrate beyond a substrate travel passage H (shown in Fig. 2A) defined between the pair of auxiliary rollers 11. With this, the distance between the substrate and the cooling surface can be further shortened, and the amount of gas leakage can be reduced while maintaining the appropriate cooling performance. The degree of projection of the cooling surface can be optimized in accordance with various film formation conditions, such as the film formation rate (evaporation rate, for example), the temperature of the film forming source, the distance between the film forming source and the substrate, the substrate traveling speed, and the type (material, thickness, width) of the substrate.

It is preferable that especially when the cooling surface projects beyond the travel passage H, the pressure of the cooling gas be adjusted such that the gap is formed between the cooling surface and the rear surface of the substrate by the cooling gas introduced to between the cooling body and the rear surface of the substrate (to be specific, such that the substrate floats from the cooling surface). This is because if the traveling substrate and the cooling surface contacts, troubles, such as damages and substrate breakages, may occur. It is preferable that the distance between the cooling body and the rear surface of the substrate at this time be 0.1 to 5 mm. If the distance is shorter than 0.1 mm, the substrate and the cooling body may contact each other by shape variation or traveling variation of the substrate. If the distance is longer than 5 mm, the gas easily leaks from the gap. Therefore, the introduction amount of gas needs to be increased, and the cooling efficiency deteriorates by the increase in size of the gap. Thus, the distance of longer than 5 mm is not preferable.

It is preferable that the pressure of the cooling gas introduced to generate the gap be 20 to 200 Pa. If the pressure is lower than 20 Pa, it is too low. Therefore, the substrate may contact the cooling body if there is the shape variation or traveling variation of the substrate. If the pressure is higher than 200 Pa, the gap between the cooling surface and the rear surface becomes large, and this causes the increase of the gas leakage and the unnecessary load on the vacuum pump.

When the thin film forming device of the present invention is not forming the thin film, to be specific, when the inside of the vacuum container 1 is not set to a pressure-reduced state, or when the heat load on the substrate is none and the cooling of the substrate is unnecessary in vacuum, the substrate can be caused to float from the cooling body by supplying compressed air or the cooling gas. However, since the gas needs to be supplied at all times during the traveling of the substrate, a large amount of gas is wasted, and the load on the vacuum pump becomes large. When the inside of the vacuum container 1 is not set to the pressure-reduced state, higher gas pressure is required to float the substrate. Here, it is preferable that in order to prevent the rear surface of the substrate and the cooling surface from contacting each other when the thin film forming device of the present invention is not forming the thin film, the thin film forming device of the present invention include a mechanism capable of changing the positional relation between the substrate and the cooling surface.

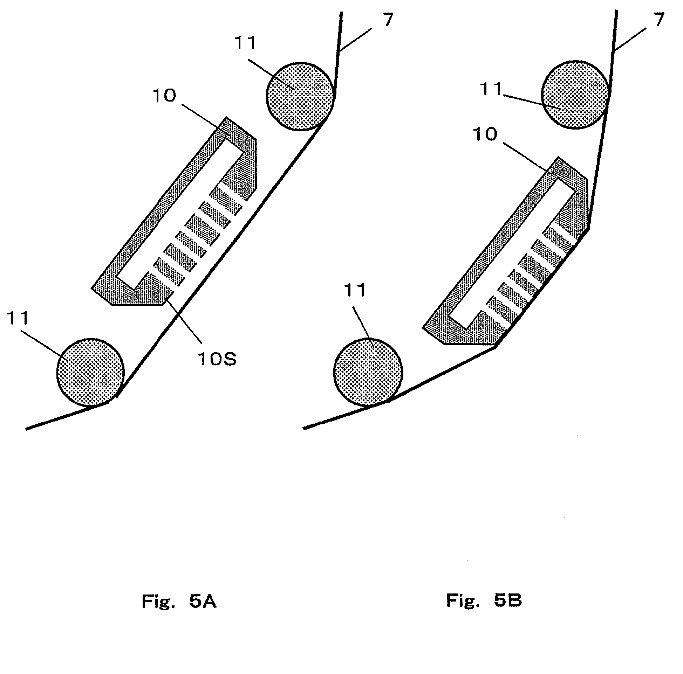

Specifically, it is desirable that the cooling body 10 or the pair of auxiliary rollers 11 be configured to be movable or both the cooling body 10 and the pair of auxiliary rollers 11 be configured to be movable, and this allow the positional relation between the rear surface of the substrate and the cooling surface to be freely selected. In Fig. 5A, the cooling body 10 is provided on a rear side with respect to the rear surface (or the auxiliary rollers 11 are provided on a front side), and the substrate is supported only by the auxiliary rollers 11. In this case, it t is desirable that the gas cooling be not performed. In Fig. 5B, the cooling body 10 is provided on the front side with respect to the rear surface (or the auxiliary rollers 11 are provided on the rear side), and the substrate is supported by the cooling surface. With this, the gas cooling can be efficiently performed. In this case, it is preferable that as described above, the substrate be caused to float from the cooling surface by the gas pressure such that the rear surface of the substrate does not contact the cooling surface. A common drive unit, such as a motor or an air compressor, can be utilized to change the positions of the cooling body 10 and the auxiliary rollers 11.

It is preferable that, for example, when the substrate 7 is fed in the atmosphere before the film formation, it be held in the state of Fig. 5A since the cooling of the substrate is unnecessary, and during the film formation, it be held in the state of Fig. 5B in order to perform the gas cooling of the substrate. Further, while the substrate is being fed to the take-up roller 4 after the film formation, the thin film forming region 9 can be shielded by a shutter (not shown) from the heat load of the film forming source (latent heat due to adherence of the evaporation material or radiation heat from the film forming source). In this case, it is preferable that the substrate 7 be held in the state of Fig. 5A again, the introduction of the cooling gas be stopped, and the load on the vacuum pump be reduced.

The actual temperature of the substrate and the actual amount of deformation of the substrate may be slightly different from the estimated temperature and the estimated amount due to the temperature variation of the film forming source 5, the distortion of the substrate, the traveling variation of the substrate, and the like. Therefore, the amount of deformation of the substrate or the temperature of the substrate can be measured during the film formation by using a laser displacement gauge or a radiation thermometer (not shown) incorporated in the cooling body 10, and the positional relation between the cooling body 10 and each of the auxiliary rollers 11 (the degree of projection of the cooling surface) shown in Fig. 5B can be finely adjusted.

Further, in bidirectional film formation in which the film formation is performed while inverting a substrate feed direction or in multiple film formation in which a plurality of films having different thicknesses and different film formation directions are stacked, the position (the tilt angle or the degree of projection) of the cooling body in the vacuum container 1 (in vacuum) can be adjusted or changed for each film formation condition, or the cooling body can be changed among a plurality of cooling bodies.

Fig. 1 shows an example of the thin film forming device configured such that the thin film forming region is formed on one inclined surface. However, in the thin film forming device of the present invention, the thin film forming region may be formed on two or more inclined surfaces. For example, the thin film forming device of the present invention may include a film formation travel system having a mountain shape, a V shape, a W shape, or a M shape. Further, the thin film forming device may be configured such that the film can be formed on each of both surfaces of the substrate, instead of the film formation on one surface of the substrate. Further, the thin film forming region may be located on a horizontal surface, instead of the inclined surface.

### Embodiment 2

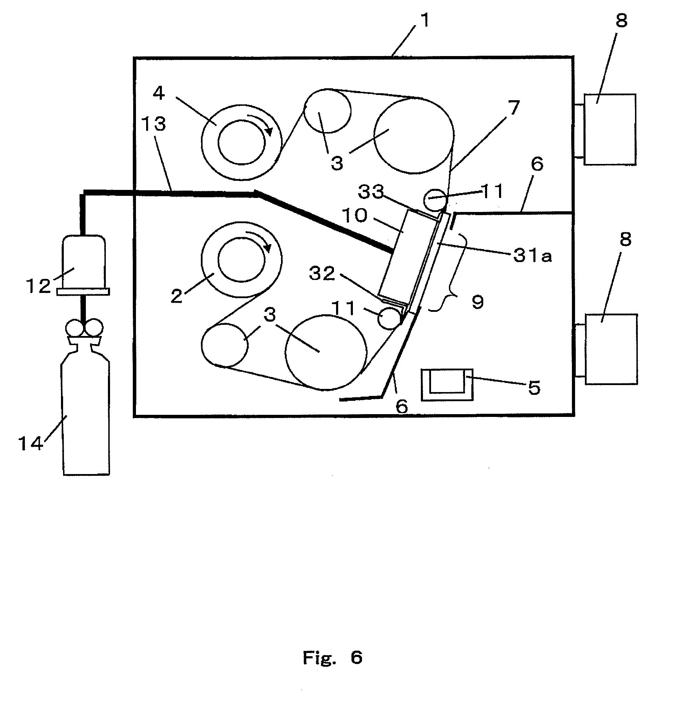

Fig. 6 is a side view schematically showing the configuration of an entire vacuum film forming device of Embodiment 2 of the present invention. Embodiment 2 is configured in the same manner as Embodiment 1 except that a gas outflow suppressing unit is provided around the cooling body 10. Hereinafter, differences between Embodiments 2 and 1 will be explained.

In the thin film forming region 9, upright blocking plates (first blocking members) 31a are respectively provided at both substrate width-direction end portions so as to be respectively opposed to width-direction end surfaces of the substrate 7. With this, the flow of the cooling gas leaking from between the cooling body 10 and the rear surface of the substrate in the substrate width direction is blocked at both substrate width-direction end portions.

Further, each of gas leakage preventing plates (third blocking members) 32 and 33 is provided on the rear surface side of the substrate so as to be located between the auxiliary roller 11 and the cooling body 10. With this, the flow of the cooling gas leaking from between the cooling body 10 and the rear surface of the substrate in the substrate longitudinal direction is blocked in the longitudinal direction of the substrate 7.

With the above configuration, since the leakage of the cooling gas from between the cooling body and the rear surface of the substrate can be suppressed, the pressure of the cooling gas between the substrate and the cooling body can be maintained at a high level. With this, the amount of gas leaking from between the cooling body and the substrate can be reduced while achieving the adequate cooling effect in the entire thin film forming region. Therefore, the decrease in the film formation rate due to the pressure increase in the film forming chamber can be avoided, and the unnecessary load on the vacuum pump can be reduced.

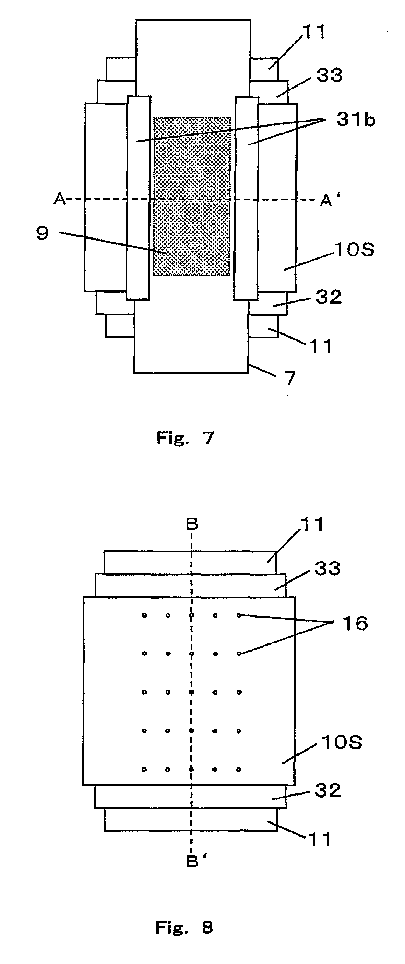

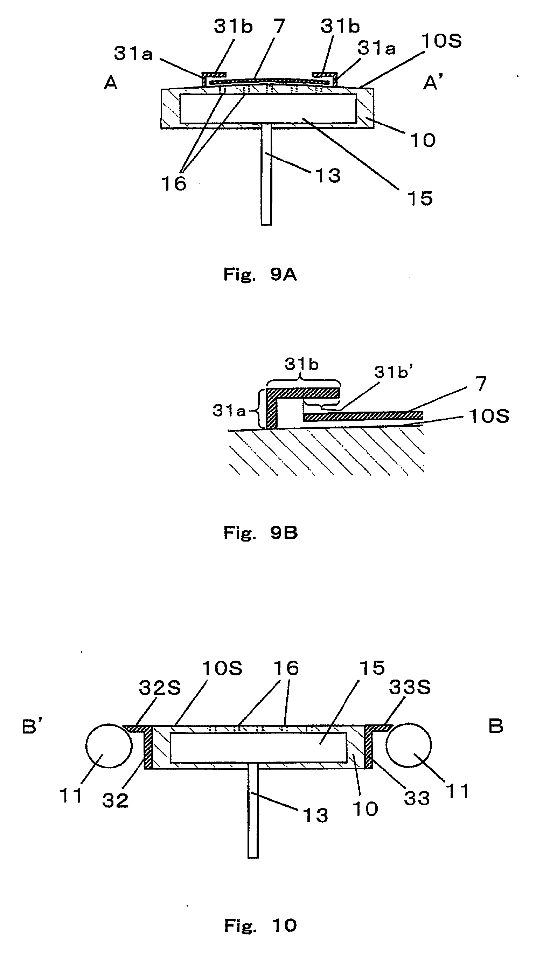

Fig. 7 is a structure diagram showing the cooling body 10 of Fig. 6 and its vicinity when viewed from the front surface side of the substrate 7. In Fig. 7, the shielding plate 6 is omitted. Fig. 8 is a structure diagram corresponding to Fig. 7 except that the substrate 7 and a blocking plate 31b are omitted. Fig. 9A is a cross-sectional view taken along line A-A' of Fig. 7. Fig. 9B is an enlarged view showing the blocking plates 31a and 31b of Fig. 9A and their vicinities. Fig. 10 is a cross-sectional view taken along line B-B' of Fig. 8.

A substrate width-direction length of the cooling surface 10s of the cooling body 10 is adjusted to be larger than the width of the substrate 7, and as shown in Fig. 7, both end portions of the cooling surface 10S are provided so as to be laterally wider than both end portions of the substrate. Further, a substrate longitudinal-direction length of the cooling surface 10s is set to be larger than the substrate longitudinal-direction length of the thin film forming region 9. With this, since the cooling surface 10s is opposed to the entire thin film forming region, the substrate can be uniformly cooled in the entire thin film forming region which receives the heat load from the film forming source.

Each of the upright shielding plates 31a is a plate-shaped member provided substantially perpendicular to the substrate. The upright shielding plates 31a are respectively provided outside both width-direction end portions of the substrate so as to be respectively opposed to end surfaces of the both end portions of the substrate. The upright shielding plates 31a block the flow of the cooling gas leaking from between the cooling body 10 and the rear surface of the substrate in the substrate width direction at the width-direction end portions of the substrate. In Fig. 9, the upright shielding plates 31a are provided on the cooling surface 10S. However, the present embodiment is not limited to this. The substrate longitudinal-direction length of the upright shielding plate 31a is set to be larger than that of the thin film forming region 9.

Further, parallel blocking plates (second blocking members) 31b are respectively provided in the vicinities of both width-direction end portions of the substrate so as to be substantially orthogonal to the upright blocking plates 31a, respectively. Each of the parallel blocking plates 31b is a plate-shaped member provided substantially parallel to the front surface of the substrate. The parallel blocking plates 31b are provided near the front surface of the substrate. As shown in Fig. 9B, the parallel blocking plate 31b is connected to the upright blocking plate 31a, and this connected body has an L-shaped cross section. With this, it is possible to block the flow of the cooling gas leaking from between the cooling body 10 and the rear surface of the substrate in a direction perpendicular to the substrate (in an upper direction in Fig. 9) at the width-direction end portions of the substrate. Further, the parallel blocking plates 31b may be provided outside the thin film forming region 9, or the parallel blocking plates 31b may limit the thin film forming region 9 in the substrate width direction.

It is preferable that at each of both end portions of the substrate, each of the parallel blocking plates 31b be provided so as to spread immediately above the cooling surface 10S and the substrate 7, to be specific, so as to extend from immediately above the cooling surface 10S and project toward immediately above the substrate 7. If the substrate width-direction length of a region 31b' of the parallel blocking plate 31b is too small, the region 31b' projecting immediately above the substrate 7, a region where the parallel blocking plate 31b and the substrate 7 overlap each other is small, and this reduces the effect of suppressing the gas leakage. In contrast, if the above length of the region 31' is too large, the effect of suppressing the gas leakage does not improve so much, but a region where the film is not formed increases. Therefore, this is not preferable. From the above viewpoints, it is preferable that the substrate width-direction length of the projecting region 31b' be suitably adjusted. For example, the appropriate substrate width-direction length of the projecting region 31b' is not smaller than 1 mm and not larger than 10 mm.

At the projecting region 31b', the substrate 7 is fed between the parallel blocking plate 31b and the cooling surface 10S. If the distance between the parallel blocking plate 31b and the cooling surface 10S is too short, the substrate and the parallel blocking plate 31b contact each other when the substrate 7 is fed, and this increases the possibility of damaging the substrate. In contrast, if the distance is too long, the effect of suppressing the gas leakage by the parallel blocking plates 31b deteriorates significantly. From the above viewpoints, it is preferable that the distance between the parallel blocking plate 31b and the cooling surface 10S be suitably adjusted. For example, the appropriate distance between the parallel blocking plate 31b and the cooling surface 10S is not shorter than 0.5 mm and not longer than 5 mm.

Fig. 9B shows the structure diagram of the cross section in which the cooling surface 10S and the upright blocking plate 31a are perpendicular to each other, and the upright blocking plate 31a and the parallel blocking plate 31b are orthogonal to each other. However, the present embodiment is not limited to this. As long as an arrangement has the effect of suppressing the gas leakage, it can be used in the same manner. For example, the upright blocking plate 31a may incline toward the substrate 7 side or may have a curved shape, instead of the plate shape. Moreover, the parallel blocking plate 31b may incline so as to get close to the substrate 7. Further, the upright blocking plate 31a and the parallel blocking plate 31b may be configured as one inseparable member or may be configured as one curved member.

The present embodiment has explained a case where both the upright blocking plates 31a and the parallel blocking plates 31b are included. However, the present embodiment is not limited to this. The effect of suppressing the gas leakage can be achieved even if the upright blocking plates 31a are included but the parallel blocking plates 31b are not included. However, an embodiment including both blocking plates is desirable. In accordance with this embodiment, the gas leakage can be suppressed more efficiently, and the pressure of the cooling gas between the cooling surface 10S and the substrate 7 can be increased adequately.

Each of the gas leakage preventing plates 32 and 33 is a member provided between the auxiliary roller 11 and the cooling body 10 so as to be located near the auxiliary roller 11, the cooling body 10, and the rear surface of the substrate. Each of the gas leakage preventing plates 32 and 33 blocks the flow of the cooling gas leaking from between the cooling surface 10S and the rear surface of the substrate in the longitudinal direction of the substrate 7. To be specific, each of the gas leakage preventing plates 32 and 33 is provided so as to fill the gap between the auxiliary roller and the cooling body, thereby blocking the flow of the gas leaking from between the auxiliary roller 11 and the cooling body 10. A minimum gap is secured between the gas leakage preventing plate and the auxiliary roller such that the gas leakage preventing plate does not disturb the rotation of the auxiliary roller. Surfaces 32S and 33S of the gas leakage preventing plates 32 and 33 are provided so as to be flush with the cooling surface 10S, the surfaces 32S and 33 S being opposed to the rear surface of the substrate. If the surfaces 32S and 33S project beyond the cooling surface 10S, they may contact the rear surface of the substrate and damage the substrate. It is preferable that the substrate width-direction length of each of the gas leakage preventing plate 32 and 33 be set to be larger than that of the thin film forming region.

The present embodiment has explained a case where the upright blocking plates 31a, the parallel blocking plates 31b, and the gas leakage preventing plates 32 and 33 are included. With this, since the gas leakage can be suppressed in both width direction and longitudinal direction of the substrate, the gas pressure between the substrate and the cooling surface can be adequately increased, which is preferable. However, the gas pressure between the substrate and the cooling surface can be maintained to some extent even in an embodiment in which the gas leakage is suppressed only in the width direction of the substrate or in an embodiment in which the gas leakage is suppressed only in the longitudinal direction of the substrate. Therefore, the present invention includes an embodiment in which only the upright blocking plates 31a (or only the upright blocking plates 31a and the parallel blocking plates 31b) is included and an embodiment in which only the gas leakage preventing plates 32 and 33 are included.

### Embodiment 3

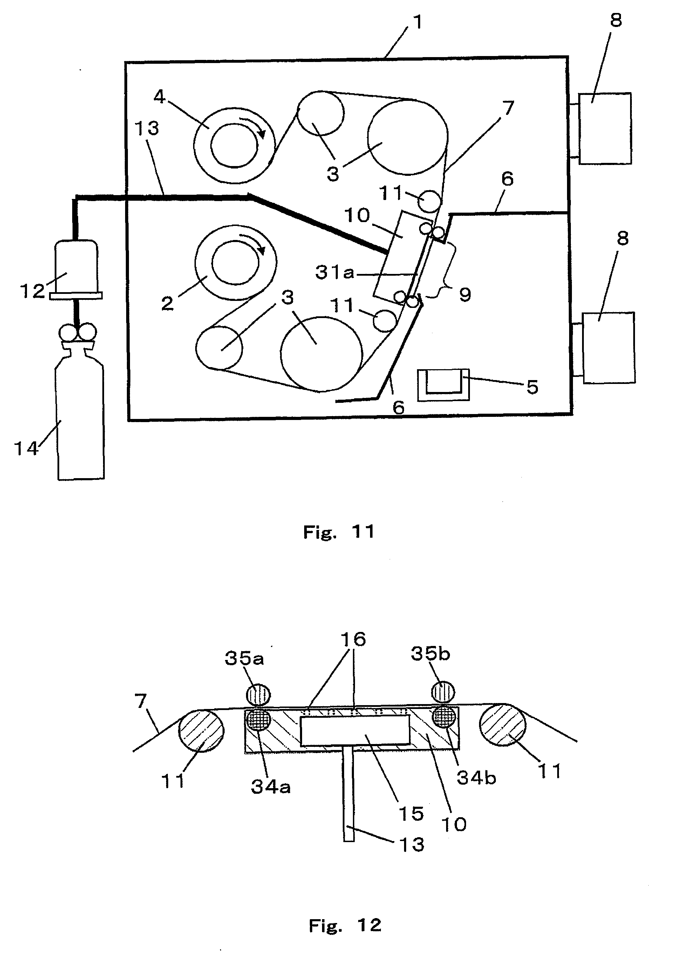

Fig. 11 is a side view schematically showing the configuration of the entire vacuum film forming device of Embodiment 3 of the present invention. In Embodiment 3, the leakage of the cooling gas from between the cooling body and the rear surface of the substrate can be suppressed as with Embodiment 2. Embodiment 3 is configured in the same manner as Embodiment 2 except for a structure around the cooling body 10. Fig. 12 is an enlarged side surface cross-sectional view showing the cooling body 10 of Fig. 11 and its vicinity. In the present embodiment, the upright blocking plates 31a and the parallel blocking plates 31b are included but the gas leakage preventing plates 32 and 33 are not included. Hereinafter, differences between Embodiments 3 and 2 will be explained.

Substrate holding rolls 35a and 35b are respectively provided on a front side and rear side of the upright blocking plates 31a and the thin film forming region 9 in the substrate longitudinal direction so as to contact the front surface of the substrate. The substrate holding roll is a member configured to hold the substrate against the cooling surface 10S from the front surface of the substrate at a position outside the thin film forming region while causing the substrate to travel.

The substrate holding rolls 35a and 35b are respectively opposed to buried rollers 34a and 34b which are buried in the cooling body 10 and whose roller surfaces are partially exposed on the cooling surface 10S. The buried rollers 34a and 34b are provided such that the exposed roller surfaces thereof contact the rear surface of the substrate. It is preferable that the exposed surfaces of the buried rolls 34a and 34b be provided so as to slightly project beyond the cooling surface 10S. Regarding the degree of projection, a distance from a highest portion of the exposed portion to the cooling surface 10S may be, for example, about 0.1 to 0.5 mm.

In this case, the substrate 7 is fed along the auxiliary rolls 11, passes through between the buried roll 34a and the substrate holding roll 35a, reaches the thin film forming region 9, and travels along the cooling surface 10S. Thus, the thin film is formed on the surface of the substrate 7. After that, the substrate 7 gets out of the thin film forming region, passes through between the buried roll 34b and the substrate holding roll 35b, and is fed along the auxiliary roll 11. As above, on the front and rear sides of the thin film forming region, the substrate holding roll 35a and the buried roller 34a sandwiches and holds the substrate from upper and lower sides of the substrate, and the substrate holding roll 35b and the buried roller 34b sandwiches and holds the substrate from upper and lower sides of the substrate. With this, the gas leakage from between the cooling surface and the substrate in the substrate longitudinal direction can be suppressed.

If the gap between the buried roll and the substrate holding roll is too small, deflections tend to be generated on the substrate 7. Therefore, folds tend to be generated, and the substrate 7 may be damaged. In contrast, if the gap is too large, a gap is generated between each roll and the substrate 7, this deteriorates the heat transfer performance, the cooling gas leaks from between the cooling body 10 and the substrate 7, and this adversely influences the film formation, which is not preferable. Specifically, it is desirable that the gap be about not less than 0.5 mm and not more than 2.0 mm.

The buried rollers 34a and 34b may be omitted. In this case, the substrate holding rolls 35a and 35b are provided so as to be opposed to the cooling surface 10S via the substrate.

With the above configuration, the gap between the rear surface of the substrate and the cooling surface on each of the front and rear sides of the thin film forming region can be maintained smaller than the gap between the rear surface of the substrate and the cooling surface in the thin film forming region. Therefore, the gas outflow from between the cooling surface and the substrate in the substrate longitudinal direction is suppressed.

The substrate width-direction length of each of the substrate holding roll and the buried roller is set to be larger than that of the thin film forming region.

### Embodiment 4

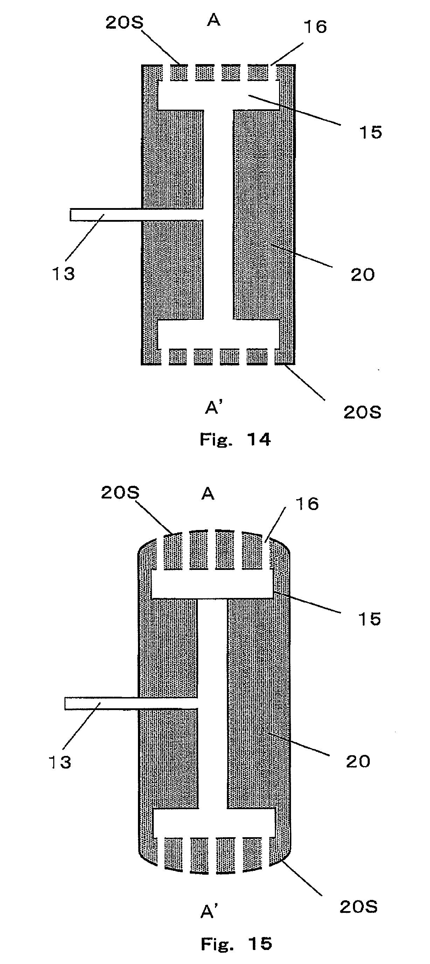

Fig. 13 is an enlarged side view schematically showing the configuration of the vicinity of the thin film forming region in the film forming device which feeds the substrate while curving the substrate by using a rotary cooling body in Embodiment 4 of the present invention. Fig. 14 is a cross-sectional view taken along line A-A' of Fig. 13 and shows a case of using a conventional planar-shape cooling body. Fig. 15 is a cross-sectional view taken along line A-A' of Fig. 13 and shows a case of using the projecting-shape cooling body of the present invention.

The configuration in Embodiment 4 is the same as that in Embodiment 1 except for the vicinity of the thin film forming region, so that an explanation thereof is omitted. In the present embodiment, the cooling body is constituted by a rotary cooling body 20 which is cooled by the cooling medium. The cooling surface of the rotary cooling body has a cylindrical shape. In terms of the use efficiency of the material, Embodiment 4 is disadvantageous compared to Embodiment 1 utilizing linear feed. However, in a case where the thin film forming region 9 is provided substantially horizontally as in Fig. 13, the decrease in the use efficiency can be suppressed. In terms of the cooling efficiency, the distance between the substrate and the cooling body is easily maintained compared to the embodiment utilizing the linear feed. Therefore, Embodiment 4 is preferable.

The cooling surface 20S of the conventional rotary cooling body has a circular shape in the side view and the substrate longitudinal-direction cross section and has a linear shape in the substrate width-direction cross section (Fig. 14). In this case, as explained in Embodiment 1, the deflections are easily generated in the substrate width direction by the thermal expansion of the substrate, and the generation of the wrinkles and undulations on the substrate cannot be avoided. In the present invention, by using the cooling body 20 in which the center portion of the cooling surface 20S projects in the substrate width-direction cross section (Fig. 15), the wrinkles and undulations are unlikely to be generated even by the thermal expansion of the substrate.

In the present embodiment, as with Embodiment 1, the projecting shape of the cooling surface in the width-direction cross section is optimized in accordance with the amount of expansion due to the temperature increase of the substrate. With this, the amount of gas leakage from between the cooling body and the substrate can be reduced while achieving the adequate cooling effect in the entire thin film forming region. Therefore, the decrease in the film formation rate due to the pressure increase in the film forming chamber can be avoided, and the unnecessary load on the vacuum pump can be reduced.

The foregoing has explained examples of the thin film forming device according to the embodiments of the present invention. However, the present invention is not limited to these embodiments. The other embodiment utilizing the cooling body in which the shape of the cooling surface in the width-direction cross section is the projecting shape can be used.

The tilt angle of the substrate in the thin film forming region can be optimized in consideration of various conditions. The oblique incidence film formation shown in Fig. 1 can form the thin film having minute spaces by the self-shadowing effect. Therefore, the oblique incidence film formation is effective to form, for example, high C/N magnetic tapes and battery negative electrodes having excellent cycle characteristics.

For example, an elongated battery polar plate can be obtained by using a copper foil as the substrate and introducing an oxygen gas according to need while evaporating silicon from the evaporation source.

Moreover, an elongated magnetic tape can be obtained by using polyethylene terephthalate as the substrate and introducing the oxygen gas while evaporating cobalt from an evaporation crucible.

The foregoing has specifically explained the embodiments for carrying out the present invention. However, the present invention is not limited to these embodiments.

As specific application examples, the foregoing has described the magnetic tape, the battery polar plate using silicon, and the like. However, the present invention is not limited to these. Needless to say, the present invention is applicable to various devices, such as capacitors, sensors, solar batteries, optical films, moisture-proof films, and electrically conductive films, which requires stable film formation.

### Industrial Applicability

In accordance with the thin film forming device and the thin film forming method of the present invention, the adequate cooling effect can be achieved in the entire thin film forming region while avoiding possible demerits caused by the gas introduction of the gas cooling method. With this, the thin film formation achieving both high material use efficiency and a high film formation rate can be achieved while preventing the deformation, meltdown, and the like of the substrate.

### Reference Signs List

- 1: vacuum container
- 2: pull-out roller
- 3: feed roller
- 4: take-up roller
- 5: film forming source
- 6: shielding plate
- 7: sub strate
- 8: exhaust unit
- 9: thin film forming region
- 10: cooling body
- 10S: cooling surface
- 11: auxiliary roller
- 12: gas flow controller
- 13: gas pipe
- 14: cooling gas supply unit
- 15: manifold
- 16: gas introduction hole
- 17: introduced gas
- 18: mask
- 20: rotary cooling body
- 31a: upright blocking plate
- 31b: parallel blocking plate
- 32, 33: gas leakage preventing plate
- 34a, 34b: buried roll
- 35a, 35b: substrate holding roll
- R: substrate feed direction

## Claims

1. A thin film forming device configured to form a thin film in vacuum on a front surface of a band-shaped substrate having the front surface and a rear surface, comprising:
a feed mechanism configured to feed the substrate;
a thin film forming unit configured to form the thin film on the front surface of the substrate in a thin film forming region while the substrate is being fed;
a cooling body configured to have a cooling surface located near the rear surface in the thin film forming region and to be cooled by a cooling medium;
a gas introducing unit configured to introduce a cooling gas to between the cooling surface and the rear surface to cool the substrate; and
a vacuum container configured to contain the feed mechanism, the thin film forming unit, the cooling body, and the gas introducing unit, wherein
in a width-direction cross section of the substrate, a center portion of the cooling surface is shaped to project toward the rear surface as compared to both end portions of the cooling surface.

2. The thin film forming device according to claim 1, wherein in the width-direction cross section of the substrate, the cooling surface has a bilaterally-symmetric shape.

3. The thin film forming device according to claim 2, wherein in the width-direction cross section of the substrate, the cooling surface has a shape represented by a catenary curve.

4. The thin film forming device according to claim 1, wherein the substrate is linearly fed in the thin film forming region.

5. The thin film forming device according to claim 4, further comprising a pair of adjusting units respectively provided on front and rear sides of the cooling surface on a feed passage of the substrate and configured to contact the rear surface to adjust the feed passage of the substrate in the vicinity of the thin film forming region.

6. The thin film forming device according to claim 5, wherein the cooling body and the pair of adjusting units are provided such that the cooling surface partially or entirely project toward the rear surface beyond a travel passage of the substrate, the travel passage being defined by the pair of adjusting units.

7. The thin film forming device according to claim 5, wherein the pair of adjusting units and/or the cooling body are configured to be movable and be able to change a positional relation between the rear surface and the cooling surface.

8. The thin film forming device according to claim 1, further comprising a gas outflow suppressing unit provided near the cooling surface to suppress outflow of the cooling gas from between the cooling surface and the rear surface.

9. The thin film forming device according to claim 8, wherein the gas outflow suppressing unit includes a first blocking member provided to be opposed to a width-direction end surface of the substrate and configured to block flow of the cooling gas flowing out from a width-direction end portion of the substrate.

10. The thin film forming device according to claim 9, wherein the gas outflow suppressing unit further includes a second blocking member provided near the front surface in the vicinity of the width direction end portion of the substrate and configured to block flow of the cooling gas flowing out from the width-direction end portion of the substrate in a direction perpendicular to the front surface.

11. The thin film forming device according to claim 8, wherein the gas outflow suppressing unit includes:
adjusting units respectively provided on front and rear sides of the cooling surface on a feed passage of the substrate and configured to contact the rear surface to adjust the feed passage of the substrate in the vicinity of the thin film forming region; and
a third blocking member provided between the cooling body and the adjusting unit to be located near the cooling body and the rear surface and configured to block flow of the cooling gas flowing out from between the cooling surface and the rear surface in a longitudinal direction of the substrate.

12. The thin film forming device according to claim 8, wherein the gas outflow suppressing unit includes substrate holding rollers respectively provided on front and rear sides of the thin film forming region on a feed passage of the substrate to contact the front surface and each configured to apply to the substrate a force toward the cooling surface to block flow of the cooling gas flowing out from between the cooling surface and the rear surface in a longitudinal direction of the substrate.

13. The thin film forming device according to claim 12, wherein:
the substrate holding rollers are provided so as to be opposed to the cooling surface via the substrate; and
a gap between each of the substrate holding rollers and the cooling surface is set such that a gap between the rear surface and the cooling surface is reduced by the substrate holding rollers.

14. The thin film forming device according to claim 12, further comprising buried rollers provided so as to be respectively opposed to the substrate holding rollers via the substrate and to contact the rear surface, and buried in the cooling body.

15. The thin film forming device according to claim 1, wherein the cooling gas is helium.

16. The thin film forming device according to claim 1, wherein:
the cooling body is a rotary cooling body in which the cooling surface has a cylindrical shape; and
in the thin film forming region, the substrate is fed while being curved along the cooling surface.

17. A thin film forming method for forming a thin film in vacuum on a front surface of a band-shaped substrate having the front surface and a rear surface, comprising:
a placing step of placing a cooling surface near the rear surface in a thin film forming region; and
a thin film forming step of, while the substrate is being fed, introducing a cooling gas to between the cooling surface and the rear surface to cool the substrate and forming the thin film on the front surface of the substrate in the thin film forming region, wherein
in a width-direction cross section of the substrate, a center portion of the cooling surface is shaped to project toward the rear surface as compared to both end portions of the cooling surface.

18. The thin film forming method according to claim 17, wherein in the thin film forming step, the cooling gas is introduced at pressure adjusted such that a gap is formed between the rear surface and the cooling surface.

19. The thin film forming method according to claim 18, wherein a distance between the rear surface and the cooling surface is 0.1 to 5 mm.

20. The thin film forming method according to claim 18, wherein the pressure is 20 to 200 Pa.

21. The thin film forming method according to claim 17, wherein in the thin film forming step, the thin film is formed while suppressing outflow of the introduced cooling gas from between the cooling surface and the rear surface.

22. The thin film forming method according to claim 21, wherein the outflow of the cooling gas is suppressed by blocking flow of the cooling gas flowing out from a width-direction end portion of the substrate.

23. The thin film forming method according to claim 22, wherein the outflow of the cooling gas is suppressed by further blocking flow of the cooling gas flowing out from the width-direction end portion of the substrate in a direction perpendicular to the front surface.

24. The thin film forming method according to claim 21, wherein the outflow of the cooling gas is suppressed by blocking flow of the cooling gas flowing out from between the cooling surface and the rear surface in a longitudinal direction of the substrate.
